(19)

**Europäisches Patentamt**

**European Patent Office**

**Office européen des brevets**

(11) **EP 4 718 715 A1**

(12) **EUROPEAN PATENT APPLICATION**

(43) Date of publication:
01.04.2026 Bulletin 2026/14

(21) Application number: 25201450.1

(22) Date of filing: 10.09.2025

(51) International Patent Classification (IPC):
$H03F\ 1/18^{(2006.01)}$    $H04L\ 25/02^{(2006.01)}$
$H03F\ 1/02^{(2006.01)}$    $H03F\ 1/42^{(2006.01)}$
$H03F\ 3/19^{(2006.01)}$    $H03F\ 3/21^{(2006.01)}$
$H03F\ 3/45^{(2006.01)}$

(52) Cooperative Patent Classification (CPC):
H03F 3/45201; H03F 1/0283; H03F 1/18;
H03F 1/42; H03F 3/19; H03F 3/211; H03F 3/45197;
H03F 3/45251; H03F 3/4565; H04L 25/0276;
H03F 2200/451

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 30.09.2024 US 202418902514

(71) Applicant: **Avago Technologies International
Sales
Pte. Limited
Singapore 768923 (SG)**

(72) Inventors:
• **Zhang, Heng**
**Irvine, 92620 (US)**
• **Cui, Delong**
**Tustin, 92782 (US)**
• **Cao, Jun**
**Irvine, 92620 (US)**
• **Li, Guansheng**
**Irvine, 92602 (US)**
• **Han, Jerry Jifang**
**Cupertino, 95014 (US)**
• **Nazemi, Ali**
**Aliso Viejo, 92656 (US)**
• **Zhang, Bo**
**Irvine, 92618 (US)**

(74) Representative: **Dilg, Haeusler, Schindelmann
Patentanwaltsgesellschaft mbH
Leonrodstraße 58
80636 München (DE)**

(54) **WIDEBAND DISTRIBUTED AMPLIFIER IN A RECEIVER**

(57) An amplifier includes a first transconductance circuit (204), which includes a first output coupled to a first current source (32, 34), a first input, a first network (205), and a cascode circuit (52, 54); and a second transconductance circuit (206), which includes a second output coupled to a second input and a second current source (64, 66); wherein the first current source (32,34) is coupled to a supply voltage (Vdd) and the second current source (64, 66) is coupled to an electrical ground; and wherein the first output is coupled to the second output.

**EP 4 718 715 A1**

FIG. 4

**Description**

BACKGROUND

Recent developments in communication and computing devices demand high data rates. For example, network devices (e.g., switches, routers, hubs, etc.) may exchange data at high speed (e.g., about 100 Gigabits per second (Gbps) or more) to stream data in real-time or process a large amount of data in a seamless manner. High-speed data communication and processing systems, including but not limited to, analog-to-digital converters (ADCs), serializer/deserializers (SERDES), Ethernet physical layers (PHY), and optical transceivers, can employ transceivers that use high-frequency signals for data transmission. A receiver part of a transceiver can amplify and/or buffer the high-frequency signals (e.g., about 50 GHz or more) prior to further processing, e.g., by a track-and-hold amplifier (THA) and ADC. A receiver can employ a multistage amplifier at the input to increase bandwidth in light of large load capacitance (e.g., an ADC). A multistage amplifier may be a circuit having two or more amplifier circuits coupled together, where each amplifier circuit can be referred to as a "stage." Some multistage amplifiers, however, may have performance deficiencies at high frequencies (e.g., frequencies above 50 Gigahertz (GHz)).

SUMMARY

In an embodiment, an amplifier is described. The amplifier can include a first transconductance circuit, which includes a first output coupled to a first current source, a first input, a first network, and a cascode circuit. The amplifier can include a second transconductance circuit, which includes a second output coupled to a second input and a second current source. The first current source can be coupled to a supply voltage and the second current source can be coupled to an electrical ground. The first output can be coupled to the second output.

In an embodiment, a receiver is described. The receiver includes an input network coupled to a transmission medium, an output network coupled to a load circuit, and an amplifier coupled between the input network and the output network. The amplifier can include a first transconductance circuit, which includes a first output coupled to a first current source, a first input, a first network, and a cascode circuit. The amplifier can include a second transconductance circuit, which includes a second output coupled to a second input and a second current source. The first current source can be coupled to a supply voltage and the second current source can be coupled to an electrical ground. The first output can be coupled to the second output.

In an embodiment, a method of amplifying a signal at a receiver is described. The method includes receiving the signal at a first input of a first transconductance circuit, receiving the signal at a second input of a second transconductance circuit, sourcing a first current by a first current source in the first transconductance circuit, and sinking the first current by a second current source in the second transconductance circuit. The method includes delaying a first signal output by the first transconductance circuit and summing the first signal as delayed with a second current signal output by the second transconductance circuit.

BRIEF DESCRIPTION OF THE DRAWINGS

Fig. 1 is a block diagram depicting a communication circuit according to some embodiments.
Fig. 2 is a block diagram depicting a receiver according to some embodiments.
Fig. 3 is a schematic diagram depicting a portion of the receiver of Fig. 2 according to embodiments.
Fig. 4 is a schematic diagram depicting a portion of a multi-stage amplifier according to some embodiments.
Fig. 5 is a schematic diagram depicting a PVT-tracking bias circuit according to some embodiments.

DETAILED DESCRIPTION

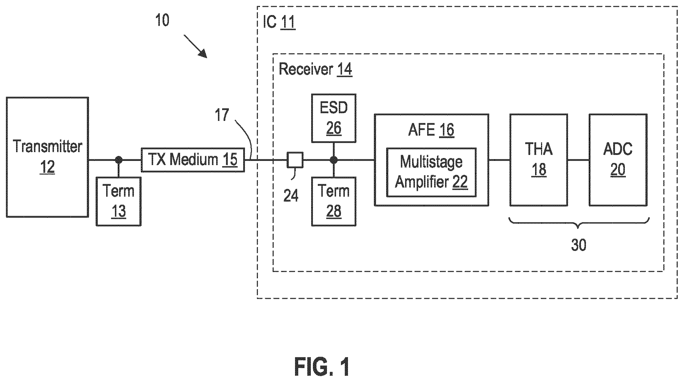

Fig. 1 is a block diagram depicting a communication circuit 10 according to some embodiments. Communication circuit 10 can include a transmitter 12 coupled to a receiver 14 by a transmission medium 15 (shown as TX medium 15). A transmitter may be a circuit that transmits a signal. Transmitter 12 may be a circuit that transmits a signal through transmission medium 15. A receiver may be a circuit that observes a signal. Receiver 14 may be a circuit that observes a signal propagating through transmission medium 15. A transmission medium may be a physical pathway for signals. Transmission medium 15 may be a physical pathway for propagating a signal between transmitter 12 and receiver 14. Receiver 14 may be formed on a semiconductor substrate of an integrated circuit (IC) 11. An IC may be a set of circuits formed by a semiconductor material and conductive interconnect disposed on the semiconductor material. Conductive interconnect can be structures that form or electrically connect circuit elements. Various semiconductor materials and semiconductor fabrication processes are known for fabricating an IC. One skilled in the art can select among one or more such materials and processes based on the description of the examples and embodiments herein. The complementary metal-oxide-semiconductor (CMOS) fabrication process for forming integrated circuits on silicon is widely used and well-known. Accordingly, for purposes of clarity, some examples and embodiments are described below within the context of an IC formed using a CMOS fabrication process.

In some examples, transmission medium 15 can include one or more transmission lines. A transmission line may be a structure designed to carry electromagnetic waves. The term applies when the structure is long enough that the wave nature of the transmission must be considered. A transmission line can be electrical, optical, or a combination of electrical and optical. The transmission line(s) of TX medium 15 can be electrical or a combination of electrical and optical (e.g., communication circuit 10 can include an electrical-to-optical converter on the transmitter-side and an optical-to-electrical converter on the receiver-side (not shown)). In some examples, transmission medium 15 can include a wireless medium (e.g., communication circuit 10 can include an antenna on the transmitter-side and an antenna on the receiver-side (not shown)).

Communication circuit 10 can include a termination 13 on the transmitter-side of TX medium 15. A termination may be an impedance that matches or approximately matches the characteristic impedance of a transmission line. While shown separate for purposes of example, in some cases, transmitter 12 can include termination 13.

Receiver 14 can include an analog front-end (AFE) 16, a track-and-hold amplifier (THA) 18, and an ADC 20. An input of AFE 16 can receive an electrical signal from transmission medium 15 through pad(s) 24. An input of THA 18 can be coupled to an output of AFE 16. An input of ADC 20 can be coupled to an output of THA 18. Pad(s) 24 may be metallization of IC 11, the metallization being coupled to transmission line(s) 17 of transmission medium 15. Transmitter 12 can couple a signal to TX medium 15 using either single-ended signaling or differential signaling. Single-ended signaling may be transmission of a signal over a single transmission line relative to electrical ground. Electrical ground may be a reference voltage against which all other voltages in communication circuit 10 can be compared (e.g., 0 V). The voltage level of the signal on the single transmission line can represent the data being transmitted. Differential signaling may be transmission of a signal over two transmission lines. The voltage difference between the two transmission lines can represent the data being transmitted. Thus, in case of single-ended signaling, receiver 14 can include a pad 24 electrically coupled to a transmission line 17. In case of differential signaling, receiver 14 can include two pads 24 electrically coupled to two transmission lines 17, respectively.

An AFE may be a circuit that conditions an analog signal. AFE 16 may be a circuit configured to condition an analog signal observed on transmission medium 15. An analog signal may be a signal continuous in time and varying in some quantity. A voltage signal, for example, may be an analog signal that varies in voltage over continuous time. The electrical signal on transmission line(s) 17 can be an analog signal conditioned by AFE 16. Receiver 14 can include electrostatic discharge (ESD) circuit(s) 26 coupled to pad(s) 24. An ESD circuit may be a circuit that provides a low-impedance path for ESD current flow (e.g., ESD diodes). Receiver 14 can include a termination 28. While shown separate for purposes of example, in some cases, AFE 16 can include termination 28.

A THA may be a circuit that captures an analog signal and holds the analog signal constant during some operation. THA 18 may be a circuit that captures the analog signal output from AFE 16 and holds the analog signal constant during operations by ADC 20 (e.g., during analog-to-digital conversion). THA 18 captures and holds an analog signal output from AFE 16 for processing by ADC 20. An ADC may be a circuit that converts an analog signal into a digital signal. ADC 20 may be a circuit that converts the analog signal as captured and held by AFE 16 to a digital signal. A digital signal may be a signal that is discrete in time and quantized in amplitude. In some embodiments, the functionality of THA 18 can be incorporated into ADC 20 and THA 18 can be omitted.

AFE 16 can condition the analog signal by amplification using a multistage amplifier 22. An amplifier may be a circuit that applies a gain to the magnitude of a signal, e.g., the analog signal at the input of AFE 16. As discussed above, a multistage amplifier can be an amplifier that includes a plurality of stages. Some embodiments of multistage amplifier 22 are described below. THA 18 and ADC 20 can be a large capacitive load of multistage amplifier 22.

Amplifiers can be used in high-speed signal processing systems. In such applications, there can be a need for an amplifier to deliver a high-speed signal (e.g., a high-frequency analog signal) to a large load capacitance at low-power consumption. Inductive peaking techniques, such as shunt peaking, series peaking, shunt-series peaking, and T-coil can be used to extend bandwidth of amplifiers. Such techniques alone, however, can be insufficient to push signal bandwidth beyond 50 GHz, for example.

An amplifier can include, for example, an input network, a transconductance circuit, and an output network. A network may be an interconnection of electrical components. An input network may be a network at an input of a circuit. An output network may be a network at an output of a circuit. A transconductance circuit may be a circuit providing transconductance, which may be the electrical characteristic relating the current through the output of the circuit to the voltage across the input of the circuit. The input network can supply a voltage across the input of the transconductance circuit and the output network can sink the current supplied through the output of the transconductance circuit. The input network can include various impedances, including resistances, capacitances, and inductances. The impedances of the input network can be associated with pads of an integrated circuit (IC) coupled to the transmission medium, electrostatic discharge (ESD) protection devices (e.g., diodes), transmission line terminations, and parasitics of devices in the transconductance circuit. The output network can include various impedances, including resistances, capacitances, and inductances. The impedances of the output network can be associated with the load of the amplifier and parasitics of devices in the transconductance circuit.

Consider an input network that includes a resistance ($R_s$) that matches the impedance of the transmission medium (e.g., a termination) and a capacitance ($C_G$) that is an input capacitance of the transconductance circuit (e.g., transistor gate capacitance). Consider an output network that includes a resistance ($R_L$) and a capacitance $C_L$ of the load of the amplifier. To achieve a larger bandwidth for a given $C_L$, a designer can: (1) make $R_L$ smaller; or (2) make the transconductance (Gm) of the transconductance circuit larger and, as a result, the $C_G$ becomes larger. $R_S$ does not scale, since the resistance should match the transmission line impedance to avoid signal reflections. Thus, a smaller bandwidth at the input network can become a bottleneck. Further, a large $C_G$ affects the termination and can fail return loss specifications. Return loss can be a measure in relative terms of the power of the signal reflected by a discontinuity in a transmission line.

A multistage distributed amplifier can include multiple transconductances coupled between the input network and the output network. A distributed amplifier may be an amplifier that incorporates transmission line theory. Each transconductance can be a stage of the multistage amplifier. The multiple transconductance stages can increase transconductance (Gm) (and hence bandwidth), while reducing input capacitance $C_G$ to meet return-loss specifications. A wideband distributed amplifier may be a distributed amplifier with a wide bandwidth. In one configuration, a multi-stage amplifier can include multiple transconductance stages having inputs coupled to the input network. The outputs of the transconductance stages can be coupled to a combiner that couples a combined output to the output network. Assuming each transconductance stage consumes a current (I), the total power of the stages can be X*I*Vdd, where X is the number of stages and Vdd is the supply voltage. That is, the power consumption of such a circuit arrangement increases linearly with the number of transconductance stages. Increasing power consumption can also lead to other negative effects, such as increasing heat produced by the amplifier, requiring additional heat dissipation and potentially undesirable modification of the device incorporating the receiver.

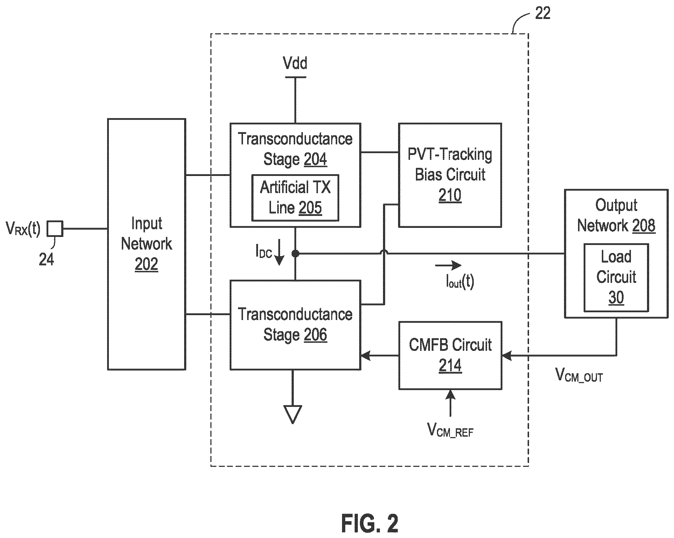

Fig. 2 is a block diagram depicting receiver 14 according to some embodiments. Receiver 14 includes an input network 202, multistage amplifier 22, and an output network 208. Multistage amplifier 22 can include a transconductance stage 204, a transconductance stage 206, a process/voltage/temperature (PVT)-tracking bias circuit 210, and a common-mode feedback (CMFB) circuit 214. Input network 202 can include a circuit of resistances, inductances, and capacitances, which can be discrete devices (e.g., resistors, capacitors, inductors) or parasitic impedances of devices (e.g., capacitance of pad(s) 24, capacitance of ESD diodes, input capacitance of transconductance stage 204, etc.). Input network 202 can be coupled between pad(s) 24 and inputs of transconductance stages 204, 206. Pad(s) 24 can receive a voltage signal $V_{RX}(t)$ from transmission line(s) 17.

Transconductance stage 204 may be a first circuit providing a first transconductance. Transconductance stage 206 may be a second circuit providing a second transconductance, which may be the same as or different from the first transconductance. Transconductance stage 204 can be coupled to a supply voltage (Vdd). Transconductance stage 206 can be coupled to electrical ground. Outputs of the transconductance stages 204, 206 can be coupled to output network 208. The output of transconductance stage 204 can be coupled to the output of transconductance stage 206 through an artificial transmission line 205 (shown as artificial TX line 205). An artificial transmission line may be a lumped-parameter circuit (e.g., a circuit having discrete circuit elements) that exhibits parameter(s) of a real transmission line (e.g., characteristic impedance, transmission time delay, phase shift, etc. or any combination thereof). Output network 208 can include load circuit 30. Each transconductance stage 204, 206 can supply a current signal as output. A current signal, for example, may be an analog signal that varies in current over continuous time. Artificial transmission line 205 can delay the current signal output from transconductance stage 204 with respect to that output from transconductance stage 206 so that the summed current signal ($I_{out}(t)$) is phase-aligned.

Transconductance stage 204 and transconductance stage 206 can include transistors, such as metal-oxide field-effect transistors (MOSFETS) formed on a semiconductor substrate of IC 11. PVT-tracking bias circuit 210 can be coupled to transconductance stage 204 and transconductance stage 206 to supply bias voltages to the transistors thereof. A bias circuit may be a circuit that provides bias voltages. The bias voltages can ensure that the transistors stay in the desired operating region throughout operation of multistage amplifier 22. Devices, such as transistors in transconductance stages 204, 206 may be subject to PVT variations that can affect operation. PVT variations may be variations in the devices themselves (process), variations in voltage applied to the devices (voltage), or variations in temperature of the devices (temperature), or any combination thereof. PVT-tracking bias circuit 210 can generate bias voltages to ensure that the transistors stay in the desired operating region in the presence of PVT variations.

In some embodiments, an input of CMFB circuit 214 can receive a common-mode voltage from output network 208 ($V_{CM\_OUT}$). A common-mode voltage may be a voltage that is common to two or more voltage signals. For example, output network 208 can supply a differential voltage signal to load circuit 30. The common-mode voltage ($V_{CM\_OUT}$) can be the voltage that is present equally in both voltage signals of the differential voltage signal regardless of the data being conveyed. CMFB circuit 214 can control transconductance stage 206 to minimize the difference between the common-mode voltage ($V_{CM\_OUT}$) and a reference common-mode voltage ($V_{CM\_REF}$).

Transconductance stages 204 and 206 can reuse the same DC current ($I_{DC}$). A DC current may be a constant current. Thus, the total power consumed by transconductance stages 204, 206 can be $I_{DC}*Vdd$. Multistage amplifier 22 can consume less power, for example, than a multi-stage amplifier discussed above that exhibits total power consumption of $X*I_{DC}*Vdd$, where X is the number of stages (by a factor of X). In addition, the DC current (I) does not flow through load circuit 30, which provides more power savings. An embodiment of multistage amplifier 22 is described below.

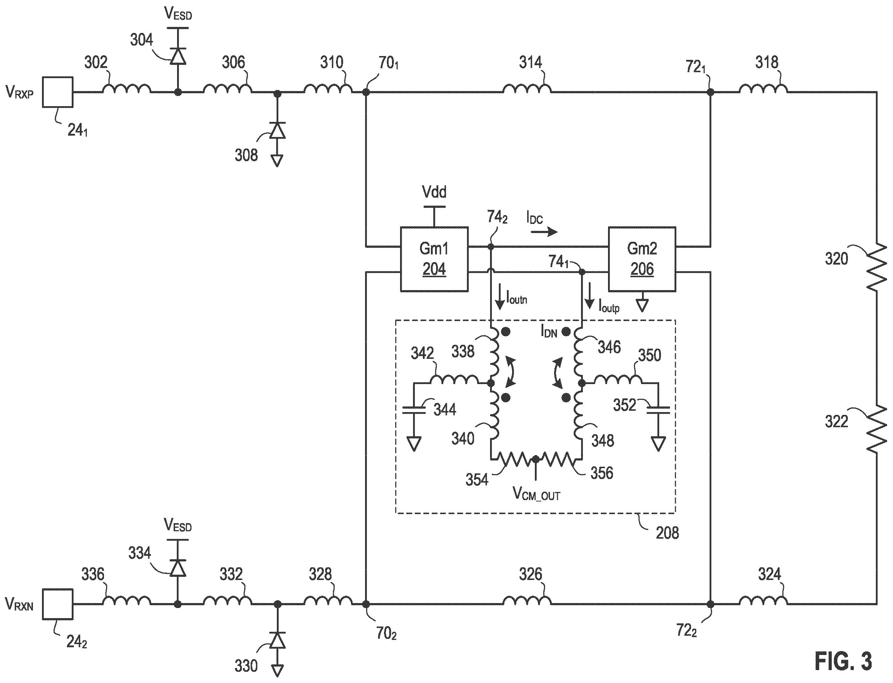

Fig. 3 is a schematic diagram depicting a portion of receiver 14 according to embodiments. In the embodiment, receiver 14 can be configured to receive a differential signal. Receiver 14 can include pads $24_1$ and $24_2$ respectively coupled to two transmission lines 17. A voltage signal $V_{RXP}(t)$ (shown simplified as $V_{RXP}$) can be received at pad $24_1$ and a voltage signal $V_{RXN}(t)$ (shown simplified as $V_{RXN}$) can be received at pad $24_2$. The voltage signal $V_{RXP}$ can be 180 degrees out-of-phase with respect to the voltage signal $V_{RXN}$. Pad $24_1$ can be coupled to node $70_1$ through a series of inductors 302, 306, and 310. A diode 304 can be coupled between an ESD voltage ($V_{ESD}$) and the node between inductors 302 and 306. A diode 308 can be coupled between electrical ground and the node between inductors 306 and 310. Diodes 304 and 308 can implement part of ESD circuit 26 to provide ESD protection at pad $24_1$. Pad $24_2$ can be coupled to node $70_2$ through a series of inductors 336, 332, 328. A diode 334 can be coupled between an ESD voltage ($V_{ESD}$) and the node between inductors 336 and 332. A diode 330 can be coupled between electrical ground and the node between inductors 332 and 328. Diodes 334 and 330 can implement part of ESD circuit 26 to provide ESD protection at pad $24_2$.

A node may be a point in a circuit where two or more circuit elements are connected. A node can be shown in the drawings as a filled circle at a wire junction. Note that, for ease of illustration, a node may be shown as two or more separate junctions connected by only wire(s) and no circuit elements (e.g., a short-circuit connection). In such case, a reference numeral assigned to the node can be at one of the junctions or at one of the wires between the junctions, all of which collectively represent the node.

An input of transconductance stage 204 (shown as Gm1 204) can be coupled to nodes $70_1$ and $70_2$. An inductor 314 can be coupled between node $70_1$ and a node $72_1$. An inductor 326 can be coupled between node $70_2$ and a node $72_2$. An input of transconductance stage 206 (shown as Gm2 206) can be coupled to nodes $72_1$ and $72_2$. An inductor 318, a resistor 320, a resistor 322, and an inductor 324 can be coupled in series between node $72_1$ and node $72_2$. Inductors 302, 306, 310, 314, and 318 can be conductors of IC 11 disposed between pad $24_1$ and resistor 320. Inductors 336, 332, 328, 326, and 324 can be conductors of IC 11 disposed between pad $24_2$ and resistor 322. Resistors 320 and 322 can be terminations of transmission lines 17 coupled to pads $24_1$ and $24_2$.

Transconductance stage 204 can be coupled to the supply voltage (Vdd). Transconductance stage 206 can be coupled to electrical ground. An output of transconductance stage 204 can be coupled to nodes $74_1$ and $74_2$. An output of transconductance stage 206 can be coupled to nodes $74_1$ and $74_2$. Output network 208 can be coupled to nodes $74_1$ and $74_2$. Transconductance stage 204 can source a DC current ($I_{DC}$) and transconductance stage 206 can sink the DC current ($I_{DCc}$). Transconductance stages 204, 206 can supply, to output network 208, a current signal $I_{outn}(t)$ (shown simplified as $I_{outn}$) from node $74_2$ and a current signal $I_{outp}(t)$ (shown simplified as $I_{outp}$) from node $74_1$.

In some embodiments, output network 208 can include a T-coil comprising inductors 346 and 348. A capacitor 352 can be coupled to the node between inductors 346 and 348 through an inductor 350. Inductors 346 and 348 of the T-coil can be coupled between node $74_1$ and a resistor 356. Output network 208 can include a T-coil comprising inductors 338 and 340. A capacitor 344 can be coupled to the node between inductors 338 and 340 through an inductor 342. Inductors 338 and 340 of the T-coil can be coupled between node $74_2$ and a resistor 354. Resistors 354 and 356 can be coupled between the T-coils. The node between resistors 354 and 356 can supply a common-mode output voltage ($V_{CM\_OUT}$). Capacitors 344 and 352 can represent capacitance of load circuit 30 (e.g., THA 18 and ADC 20). Inductors 342 and 350 can be conductors of IC 11 coupling load circuit 30 to the T-coils. Output network 208 shown in Fig. 3 can be just one example output network and those skilled in the art will appreciate that other types of output networks can be employed to couple transconductance stages 204, 206 to load circuit 30.

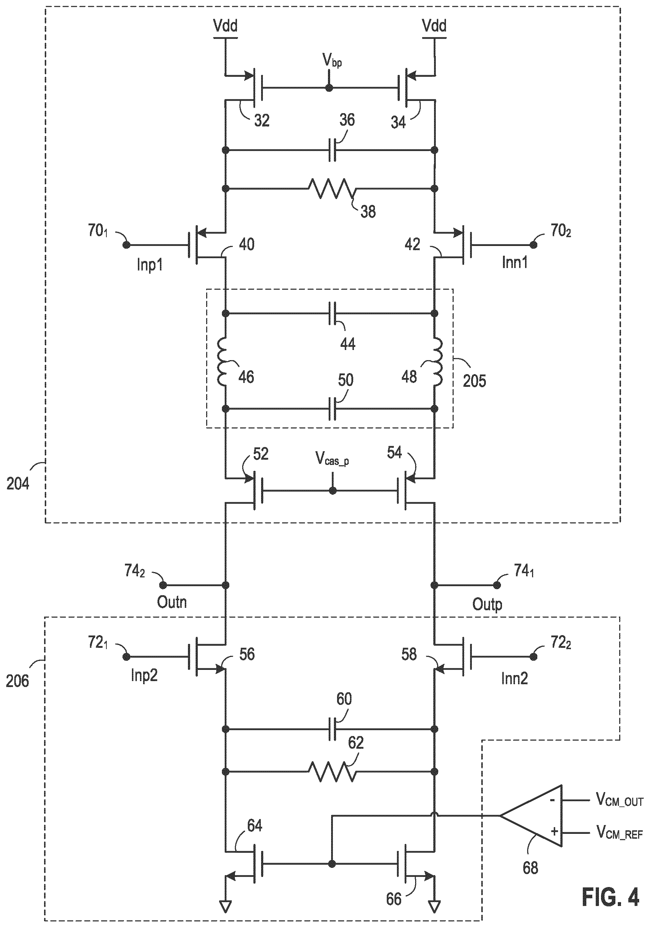

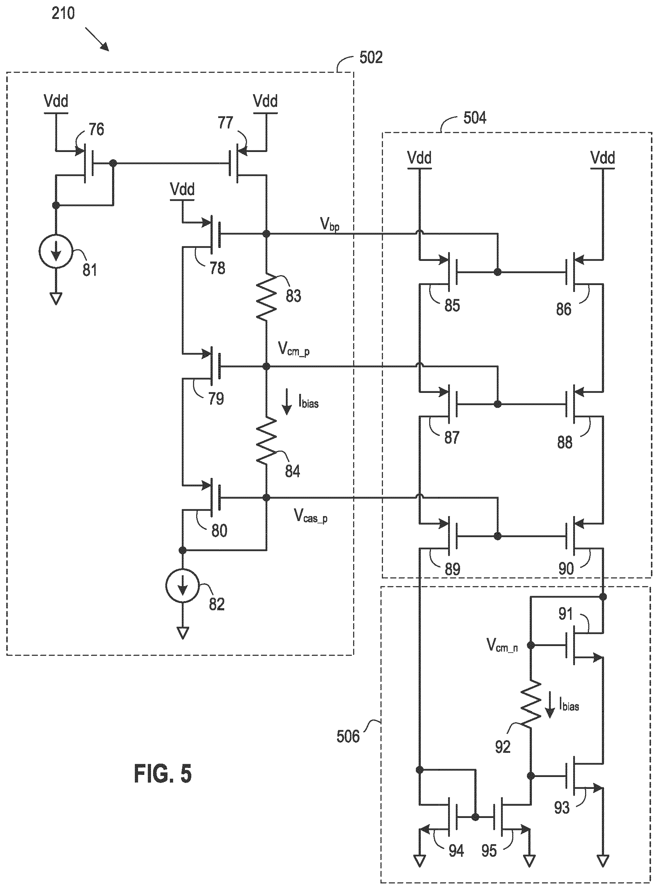

Fig. 4 is a schematic diagram depicting a portion of multi-stage amplifier 22 according to some embodiments. Multi-stage amplifier 22 can include transconductance stage 204, transconductance stage 206, and an operational amplifier 68. Transconductance stages 204, 206 can include transistors. The transistors can be field effect transistors (FETs). A FET can be a four-terminal device having gate, source, drain, and substrate terminals. Unless otherwise indicated, the transistors described herein have their substrate terminals coupled to their source terminals and, as such, the substrate terminals are not explicitly shown. FETs can be p-channel FETs or n-channel FETs, where n and p refer to the type of doping in the semiconductor material and the type of majority charge carrier, as is known in the art. Consistent with convention, any n-channel transistors are shown schematically with the source as an arrow facing away from the gate and any p-channel transistors are shown schematically with the source as an arrow facing towards the gate. There are many types of FETs known in the art. One skilled in the art can select among one or more such FETs based on the description of the examples and embodiments herein. Metal-oxide semiconductor field-effect transistors (MOSFETs) are widely used and well-known FETs in CMOS-based ICs. P-channel MOSFETs can be referred to as PMOS transistors and N-channel MOSFETs can be referred to as NMOS transistors. Accordingly, for purposes of clarity, various examples and embodiments are described below within the context of NMOS transistors, PMOS transistors, or a combination thereof. Operational amplifier 68 can implement CMFB circuit 214. For clarity, PVT-tracking bias circuit 210 is omitted from Fig. 4. An embodiment of PVT-tracking bias circuit 210 is shown in Fig. 5.

Transconductance stage 204 can include a current source comprising transistors 32 and 34. Transistors 32, 34 can be p-type metal oxide semiconductor (PMOS) transistors. Sources of transistors 32, 34 can be coupled to the supply voltage (Vdd). The gate of transistor 32 can be coupled to the gate of transistor 34. The gates of transistors 32, 34 can receive a bias voltage $(V_{bp})$, which can be generated by PVT-tracking bias circuit 210 as described below. Transconductance stage 204 can include an input comprising a pair of transistors 40 and 42. Transistors 40, 42 can be PMOS transistors. The source of transistor 40 can be coupled to the drain of transistor 32. The source of transistor 42 can be coupled to the drain of transistor 34. The gate of transistor 40 can be coupled to node $70_1$. The gate of transistor 40 can be an input (Inp1) of transconductance circuit 204 configured to receive the voltage signal $V_{RXP}$ from input network 202. The gate of transistor 42 can be coupled to node $70_2$. The gate of transistor 42 can be an input (Inn1) of transconductance circuit 204 configured to receive the voltage signal $V_{RXN}$ from input network 202. An impedance can be coupled between sources of transistors 40, 42. In the example shown, such an impedance can include a capacitor 36 in parallel with a resistor 38.

Transconductance stage 204 can include a cascode circuit comprising transistors 52 and 54. Transistors 52, 54 can be PMOS transistors. Transistors may be coupled in cascode when the drain of a first transistor is coupled to the source of a second transistor, the gate of the first transistor receives a voltage signal as input, and the drain of the second transistor supplies an output signal. In such a circuit arrangement, the second transistor may be referred to as a cascode transistor. A cascode circuit may be a circuit having cascode transistors. Transistor 52 can be coupled in cascode with transistor 40 and transistor 54 can be coupled in cascode with transistor 42. The gate of transistor 52 can be coupled to the gate of transistor 54. The gates of transistors 52, 54 can receive a bias voltage $(V_{cas\_p})$, which can be generated by PVT-tracking bias circuit 210 as described below. The drain of transistor 52 can be coupled to node $74_2$. The drain of transistor 54 can be coupled to node $74_1$. The drain of transistor 52 can be an output of transconductance stage 204 shared with transconductance stage 206 (Outn). The drain of transistor 54 can be another output of transconductance stage 204 shared with transconductance stage 206 (Outp).

Transconductance stage 204 can include artificial transmission line 205 coupled between the input and the cascode. Artificial transmission line 205 can include a capacitor 44, an inductor 46, an inductor 48, and a capacitor 50. Inductor 46 can be coupled between the drain of transistor 40 of the input and the source of transistor 52 of the cascode. Inductor 48 can be coupled between the drain of transistor 42 of the input and the source of transistor 54 of the cascode. Capacitor 44 can be coupled between the drains of the transistors 40 and 42. Capacitor 50 can be coupled between the sources of transistors 52 and 54.

Transconductance stage 206 can include an input comprising transistors 56 and 58. Transistors 56, 58 can be n-type metal oxide semiconductor (NMOS) transistors. The gate of transistor 56 can be coupled to node $72_1$. The gate of transistor 56 can be an input (Inp2) of transconductance circuit 206 configured to receive the voltage signal $V_{RXP}$ from input network 202. The gate of transistor 58 can be coupled to node $72_2$. The gate of transistor 58 can be an input (Inn2) of transconductance circuit 206 configured to receive the voltage signal $V_{RXN}$ from input network 202. The drain of transistor 56 can be coupled to node $74_2$. The drain of transistor 58 can be coupled to node $74_1$.

Transconductance stage 206 can include a current source comprising transistors 64 and 66. Transistors 64, 66 can be NMOS transistors. The sources of transistors 64, 66 can be coupled to electrical ground. The gate of transistor 64 can be coupled to the gate of transistor 66. The gates of transistors 64, 66 can receive a bias voltage from the output of operational amplifier 68. The source of transistor 56 can be coupled to the drain of transistor 64. The source of transistor 58 can be coupled to the drain of transistor 66. An impedance can be coupled between the sources of transistors 56, 58. In the example shown, such an impedance can include a capacitor 60 in parallel with a resistor 62.

Operational amplifier 68 can include a non-inverting input (+) coupled to receive a reference common-mode voltage $(V_{CM\_REP})$. Operational amplifier 68 can include an inverting input (-) coupled to receive the common-mode output voltage $(V_{CM\_OUT})$ from output network 208. For example, in the embodiment shown in Fig. 3, the inverting input (-) of operational amplifier 68 can be coupled to the node between resistors 354 and 356. The output of operational amplifier 68 can be coupled to the gates of transistors 64 and 66.

In operation, transconductance stage 204 can be stacked with transconductance stage 206. Transconductance stage 204 can source a DC current $(I_{DC})$ and transconductance stage 206 can sink the DC current ($I_{DC}$) sourced from transconductance stage 204. The DC current ($I_{DC}$) does not flow through resistance of load circuit 30. Artificial transmission line 205 and the cascode (transistors 52, 54) can delay the output current signal of transconductance stage 204. Such a delay can be omitted from transconductance circuit 206. The delay added to the output current signal of transconductance stage 204 can account for the delay between the voltage signals at the input of transconductance stage 206 and the voltage signals at the input of transconductance stage 204 (e.g., due to inductors 314 and 326). In this manner, the current signals output from transconductance stages 204 and 206 can be phase-aligned when summed at the output. Phase-align may be a condition where the phases of two signals are the same or substantially the same. Transconductance stage 206 omits cascode transistors, which can save voltage headroom and power while maintaining all functionalities of a distributed amplifier. Omission of the cascode transistors from transconductance stage 206 can also avoid using a higher supply voltage (Vdd) and can achieve improved device reliability. Operational amplifier 68 can implement CMFB circuit 214 to sense the common-mode output voltage ($V_{CM\_OUT}$) and adjust the current source in transconductance stage 206 accordingly.

Transistors 32 and 34, transistors 40 and 42, transistors 52 and 54, and transistors 56 and 58 can be biased to operate in the desired operation region. Biasing of transistors 64 and 66 can be performed by operational amplifier 68 as described above. The bias voltages for the other transistors can be generated by a resistor divider or current mirror. However, the performance of such approaches can suffer in the presence of PVT variations. For a low-power design, a lower supply voltage (Vdd) can be used. A lower supply voltage, however, can reduce the voltage headroom for each transistor in the signal path. With reduced voltage headroom, it can be challenging to keep the transistors operating in the desired region in the presence of PVT variations. In some embodiments, multistage amplifier 22 can include PVT-tracking bias circuit 210 to overcome such challenges.

Fig. 5 is a schematic diagram depicting PVT-tracking bias circuit 210 according to some embodiments. PVT-tracking bias circuit 210 can include transistors 76 and 77 and a current source 81. The sources of transistors 76 and 77 can be coupled to the supply voltage (Vdd). The gate of transistor 76, the gate of transistor 77, and the drain of transistor 76 can be coupled at a node. Current source 81 can be coupled between the drain of transistor 76 and electrical ground. Transistors 76, 77 can be PMOS transistors. Current source 81 can be a bandgap over calibrated resistor (BGCR) current source. A BGCR current source can be a bandgap voltage generator coupled to a calibrated resistor. A calibrated resistor may be a resistor, formed on the IC, that is calibrated using an external resistor (off the IC). Hence, process, temperature, and voltage variations for the calibrated resistor can be minimized.

PVT-tracking bias circuit 210 can include transistors 78, 79, and 80 and a current source 82. The source of transistor 78 can be coupled to the supply voltage (Vdd). The drain of transistor 78 can be coupled to the source of transistor 79. The drain of transistor 79 can be coupled to the source of transistor 80. Current source 82 can be coupled between the drain of the transistor 80 and electrical ground. Transistors 78, 79, and 80 can be PMOS transistors. Current source 82 can be a BGCR current source. PVT-tracking bias circuit 210 can include resistors 83 and 84 coupled in series between the drain of transistor 77 and the gate of transistor 80. The gate of transistor 80 can be coupled to the drain of transistor 80. The gate of transistor 79 can be coupled to a node between resistor 83 and resistor 84. Transistors 76, 77, 78, 79, and 80, current sources 81 and 82, and resistors 83 and 84 can form a cascode PMOS current mirror 502 with inserted resistors (resistors 83, 84) to provide bias voltages for transconductance stage 204 and a PMOS current source 504. A current mirror may be a current source that supplies a second current that is referenced to a first current.

PVT-tracking bias circuit 210 can include transistors 85 and 86. The sources of transistors 85 and 86 can be coupled to the supply voltage (Vdd). Transistors 85 and 86 can be PMOS transistors. The gates of transistor 78, transistor 85, and transistor 86 can be coupled to a node, which supplies the bias voltage ($V_{bp}$) to the current source in transconductance stage 204 (e.g., transistors 32, 34). PVT-tracking bias circuit 210 can include transistors 87 and 88. The source of transistor 87 can be coupled to the drain of transistor 85. The source of transistor 88 can be coupled to the drain of transistor 86. Transistors 87 and 88 can be PMOS transistors. The gates of transistor 79, 87, and 88 can be coupled to a node, which supplies a bias voltage $V_{cm\_p}$. The bias voltage $V_{cm\_p}$ can be summed with the voltage signals $V_{RXP}$ and $V_{RXN}$ at the input of transconductance stage 204 (e.g., at the gates of transistors 40 and 42 being the inputs Inp1 and Inn1, respectively).

PVT-tracking bias circuit 210 can include transistors 89 and 90. The source of transistor 89 can be coupled to the drain of transistor 87. The source of transistor 90 can be coupled to a drain of transistor 88. Transistors 89 and 90 can be PMOS transistors. The gates of transistor 80, transistor 89, and transistor 90 can be coupled to a node, which supplies the bias voltage $V_{cas\_p}$ to the cascode in transconductance stage 204 (e.g., transistors 52 and 54). Transistors 85, 86, 87, 88, 89, and 909 can form PMOS current source 504.

PVT-tracking bias circuit 210 can include transistors 91, 93, 94, and 95 and a resistor 92. Transistors 91, 93, 94, and 95 can be NMOS transistors. The drain of transistor 91 can be coupled to the drain of transistor 90. The source of transistor 91 can be coupled to the drain of transistor 93. The source of transistor 93 can be coupled to electrical ground. The drain of transistor 94 can be coupled to the drain of transistor 89. Resistor 92 can be coupled between the gates of transistors 91 and 93. The gate of transistor 91 can be further coupled to the node formed by the drains of transistors 90 and 91. The drain of transistor 95 can be coupled to the gate of transistor 93. The gate of transistor 94 can be coupled to the gate of transistor 95. The node formed by the gates of transistors 94 and 95 can be coupled to the drain of transistor 94. The node formed at the gate of transistor 91 can supply a bias voltage $V_{cm\_n}$. The bias voltage $V_{cm\_n}$ can be summed with the voltage signals $V_{RXP}$ and $V_{RXN}$ at the input of transconductance stage 206 (e.g., at the gates of transistors 56 and 58 being the inputs Inp2 and Inn2, respectively). Transistors 91, 93, 94, and 95 and resistor 92 can be a cascode NMOS current mirror 506 that provides bias voltages for transconductance stage 206.

In operation, a current $I_{bias}$ flows through resistor 84 and resistor 92. The bias voltage $V_{cm\_p}$ is as follows:

$$V_{cm\_p} = V_{dd} - V_{sg,78} - I_{bias}*R_{83},$$

where $V_{dd}$ is the supply voltage, $V_{sg,78}$ is the source-to-gate voltage of transistor 78, and $R_{83}$ is the resistance of the resistor 83. The bias voltage $V_{cas\_p}$ is as follows:

$$V_{cas\_p} = V_{dd} - V_{sg,78} - I_{bias}*(R_{83} + R_{84})$$

where $V_{dd}$ is the supply voltage, $V_{sg,78}$ is the source-to-gate voltage of transistor 78, $R_{83}$ is the resistance of the resistor 83, and $R_{84}$ is the resistance of the resistor 83. The bias voltage $V_{cm\_n}$ is as follows:

$$V_{cm\_n} = V_{gs,93} + I_{bias}*R_{92},$$

where $V_{gs,93}$ is the gate-to-source voltage of transistor 93, and $R_{92}$ is the resistance of the resistor 92. The bias voltage $V_{bp}$ can be $V_{dd} - V_{sg,78}$, where $V_{dd}$ is the supply voltage, $V_{sg,78}$ is the source-to-gate voltage of transistor 78.

Referring to Fig. 4, given the bias voltages provided by PVT-tracking bias circuit 210 described above, the drain-to-source voltage ($V_{ds}$) of each of transistors 32 and 34 can be $I_{bias}*R_{83}$, where $R_{83}$ is the resistance of resistor 83. The drain-to-source voltage ($V_{ds}$) of each of transistors 40 and 42 can be $I_{bias}*R_{84}$, where $R_{84}$ is the resistance of resistor 84. The drain-to-source voltage ($V_{ds}$) of each of transistors 64 and 66 can be $I_{bias}*R_{92}$, where $R_{92}$ is the resistance of resistor 92. The source-to-gate voltage of each of transistors 40 and 42, the source-to-gate voltage of each of transistors 52 and 54, and the source-to-gate voltage of transistor 78 can be equal. The source-to-gate voltage of each of transistors 56 and 58 can be equal to the source-to-gate voltage of transistor 93. Resistors 83, 84, and 92 can be implemented using calibrated resistors.

The embodiments described above for multi-stage amplifier 22 are capable of variation. In some embodiments, the input current in PVT-tracking bias circuit 210 can be BGCR current sources as described above. Alternatively, current sources 81 and 82 can be bandgap over resistance (e.g., bandgap voltage generated paired with a resistor). In some embodiments, artificial transmission line 205 can be disposed in transconductance circuit 204 between the input and the cascode as described above. The current source in transconductance circuit 206 (e.g., transistors 64 and 66) can be controlled by CMFB circuit 214 or only partially controlled by CMFB 214. "Partially controlled" can be when only a fraction of transistors 64 and transistor 66 have the gates connected to the output of operational amplifier 68 and the rest of transistors 64 and 66 have a fixed gate voltage control. In some embodiments, transconductance stage 204 can include an impedance formed from capacitor 36 and resistor 38 to provide a degeneration network. Likewise, transconductance stage 206 can include an impedance formed from capacitor 60 and resistor 62 to provide a degeneration network. Alternatively, the degeneration network in either or both of transconductance stages 204, 206 can be pure resistance or pure capacitance. The phase alignment of output currents can be achieved using different structures, including transmission lines, artificial transmission line (as shown), or buffers, or a combination of such structures. Output network 208 can use various inductive peaking techniques, such as series peaking, shunt peaking, shunt-series peaking, or T-coil peaking (as shown in the example of Fig. 3). Output network 208 can directly drive the capacitive load (e.g., ADC 20) or other intermediate stages, such as transimpedance amplifier (TIA) stages.

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

As used herein, the term "couple" or "connect" and its derivatives include: (a) electrical and communicative coupling or connecting; and (b) do not imply a direct coupling or connection, but rather may include intervening elements, unless described as "directly coupled" or "directly connected."

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

**Claims**

1. An amplifier, comprising:

   a first transconductance circuit, which includes a first output coupled to a first current source, a first input, a first network, and a cascode circuit; and
   a second transconductance circuit, which includes a second output coupled to a second input and a second current source;
   wherein the first current source is coupled to a supply voltage and the second current source is coupled to an electrical ground; and
   wherein the first output is coupled to the second output.

2. The amplifier of claim 1, wherein
   the first transconductance circuit is configured to generate a first current signal at the first output in response to a voltage signal at the first input, wherein the second transconductance circuit is configured to generate a second current signal at the second output in response to the voltage signal at the second input, and wherein the first network is configured to delay the first current signal to phase-align the first and second current signals.

3. The amplifier of claim 2, wherein
   the first network comprises an artificial transmission line.

4. The amplifier of any one of the claims 1 to 3, wherein
   the first input comprises a first pair of transistors, and wherein the first transconductance circuit includes a second network coupled between sources of the transistors in the first pair.

5. The amplifier of claim 4, wherein
   the second input comprises a second pair of transistors, and wherein the second transconductance circuit includes a third network coupled between sources of the transistors in the second pair.

6. The amplifier of any one of the claims 1 to 5, wherein the first current source comprises a first pair of transistors, the first input comprises a second pair of transistors, the cascode circuit comprises a third pair of transistors, the second input comprises a fourth pair of transistors, and the second current source comprises a fifth pair of transistors.

7. The amplifier of claim 6, further comprising:
   a bias circuit configured to generate a first bias voltage for the first pair of transistors, a second bias voltage for the second pair of transistors, a third bias voltage for the third pair of transistors, and a fourth bias voltage for the fourth pair of transistors.

8. A receiver, comprising:

   an input network coupled to a transmission medium;
   an output network coupled to a load circuit; and
   an amplifier coupled between the input network and the output network, the amplifier comprising:

   a first transconductance circuit, which includes a first output coupled to a first current source, a first input, a first network, and a cascode circuit; and
   a second transconductance circuit, which includes a second output coupled to a second input and a second current source;

wherein the first current source is coupled to a supply voltage and the second current source is coupled to an electrical ground; and
wherein the first output is coupled to the second output.

9. The receiver of claim 8, wherein

the first transconductance circuit is configured to generate a first current signal at the first output in response to a voltage signal at the first input, wherein the second transconductance circuit is configured to generate a second current signal at the second output in response to the voltage signal at the second input, and wherein the first network is configured to delay the first current signal to phase-align the first and second current signals;
wherein in particular
the input network includes an impedance coupled between the first input and the second input, and wherein the voltage signal at the second input is delayed by the impedance with respect to the voltage signal at the first input;
and/or wherein in particular
the first network comprises an artificial transmission line.

10. The receiver of claim 8 or 9, wherein

the first input comprises a first pair of transistors, and wherein the first transconductance circuit includes a second network coupled between sources of the transistors in the first pair;
wherein in particular
the second input comprises a second pair of transistors, and wherein the second transconductance circuit includes a third network coupled between sources of the transistors in the second pair.

11. The receiver of any one of the claims 8 to 10, wherein

the first current source comprises a first pair of transistors, the first input comprises a second pair of transistors, the cascode circuit comprises a third pair of transistors, the second input comprises a fourth pair of transistors, and the second current source comprises a fifth pair of transistors; wherein in particular
the receiver further comprises:
a bias circuit configured to generate a first bias voltage for the first pair of transistors, a second bias voltage for the second pair of transistors, a third bias voltage for the third pair of transistors, and a fourth bias voltage for the fourth pair of transistors.

12. The receiver of any one of the claims 8 to 11, wherein

the load circuit comprises an analog-to-digital converter, ADC;
wherein in particular
the load circuit comprises a track-and-hold amplifier (THA) couple to the ADC.

13. A method of amplifying a signal at a receiver, comprising:

receiving the signal at a first input of a first transconductance circuit;
receiving the signal at a second input of a second transconductance circuit;
sourcing a first current by a first current source in the first transconductance circuit;
sinking the first current by a second current source in the second transconductance circuit;
delaying a first signal output by the first transconductance circuit; and
summing the first signal as delayed with a second current signal output by the second transconductance circuit.

14. The method of claim 13, wherein
the first input and the second input are coupled to an input network, and wherein the signal at the second input is delayed with respect to the signal at the first input by the input network.

15. The method of claim 13 or 14, further comprising:
coupling a sum of the first and second current signals to a load circuit, the load circuit including an analog-to-digital converter, ADC of the receiver.

FIG. 1

22

Vdd

Input Network 202

$V_{RX}(t)$

24

Transconductance Stage 204

Artificial TX Line 205

PVT-Tracking Bias Circuit 210

Output Network 208

Load Circuit 30

$I_{DC}$

$I_{out}(t)$

Transconductance Stage 206

CMFB Circuit 214

$V_{CM\_OUT}$

$V_{CM\_REF}$

FIG. 2

FIG. 3

EP 4 718 715 A1

FIG. 4

FIG. 5

Europäisches
Patentamt
European
Patent Office
Office européen
des brevets

# EUROPEAN SEARCH REPORT

**Application Number**

EP 25 20 1450

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/327623 A1 (LI GUANSHENG [US] ET AL) 12 October 2023 (2023-10-12)<br>* paragraphs [0001] - [0060]; figures 1A-6 * | 1-15 | INV.<br>H03F1/18<br>H04L25/02<br>H03F1/02<br>H03F1/42<br>H03F3/19<br>H03F3/21<br>H03F3/45 |
| A | LI FANGZHU ET AL: "A 60-GHz Distributed CTLE with Complementary Units for 240-Gb/s Receiver in 28-nm CMOS",<br>2024 6TH INTERNATIONAL CONFERENCE ON CIRCUITS AND SYSTEMS (ICCS), IEEE,<br>20 September 2024 (2024-09-20), pages 189-192, XP034817704,<br>DOI: 10.1109/ICCS62517.2024.10846602<br>[retrieved on 2025-01-23]<br>* page 189, left-hand column, line 20 - page 192, right-hand column, line 10; figures 1-13 * | 1-15 | |
| A | HAYUN CHUNG ET AL: "Design considerations for ADC-based backplane receivers",<br>CIRCUITS AND SYSTEMS (MWSCAS), 2011 IEEE 54TH INTERNATIONAL MIDWEST SYMPOSIUM ON, IEEE,<br>7 August 2011 (2011-08-07), pages 1-4, XP031941224,<br>DOI: 10.1109/MWSCAS.2011.6026280<br>ISBN: 978-1-61284-856-3<br>* page 1, left-hand column, line 8 - page 4, left-hand column, line 4; figures 1-7 * | 1-15 | |

**TECHNICAL FIELDS SEARCHED (IPC)**

H03F
H04L

The present search report has been drawn up for all claims

| Place of search | Date of completion of the search | Examiner |
|---|---|---|
| The Hague | 22 January 2026 | Fedi, Giulio |

EPO FORM 1503 03.82 (P04C01)

## ANNEX TO THE EUROPEAN SEARCH REPORT
## ON EUROPEAN PATENT APPLICATION NO.

EP 25 20 1450

This annex lists the patent family members relating to the patent documents cited in the above-mentioned European search report.
The members are as contained in the European Patent Office EDP file on
The European Patent Office is in no way liable for these particulars which are merely given for the purpose of information.

22-01-2026

| Patent document cited in search report | Publication date | Patent family member(s) | Publication date |
|---|---|---|---|
| US 2023327623    A1 | 12-10-2023 | CN    116896342 A<br>DE 102023001349 A1<br>US    2023327623 A1 | 17-10-2023<br>19-10-2023<br>12-10-2023 |

EPO FORM P0459

For more details about this annex : see Official Journal of the European Patent Office, No. 12/82